# EUROPÄISCHE PATENTSCHRIFT

(11) **EP 2 194 768 B1**
(45) Veröffentlichungstag und Bekanntmachung des Hinweises auf die Patenterteilung: **13.02.2013**
(21) Anmeldenummer: 09177871.2
(22) Anmeldetag: 03.12.2009
(51) Int. Cl.: H05K 5/06, H02J 7/34, H01M 2/10, H01M 16/00

(54) **Energiespeichereinrichtung**
Energy storage device
Dispositif d'emmagasinage d'énergie

(30) Priorität: 04.12.2008 DE 102008062657
(43) Veröffentlichungstag der Anmeldung: 09.06.2010
(73) Patentinhaber: Flextronics International Kft., Tab 8660 (HU)
(72) Erfinder: Stengel, Peter, 73235 Weilheim/Teck (DE)
(74) Vertreter: Rupprecht, Kay

(56) Entgegenhaltungen:
- EP-A1- 1 460 660
- EP-A2- 1 422 983
- EP-A2- 1 820 624
- DE-A1- 10 213 570
- DE-A1-102005 018 339
- US-A- 5 880 951

## Beschreibung

Die Erfindung betrifft eine Energiespeichereinrichtung umfassend eine Wandlereinheit und einen mit der Wandlereinheit zusammenwirkenden Kondensatormodul.

Derartige Energiespeichereinrichtungen, insbesondere für Bordnetze von Kraftfahrzeugen, sind aus dem Stand der Technik bekannt, wobei bei diesen die tatsächliche Integration in das Kraftfahrzeug nicht gelöst ist. Eine Energiespeichereinrichtung nach dem Oberbegriff von Anspruch 1 wird in US 5 880 951 gezeigt.

Der Erfindung liegt daher die Aufgabe zugrunde, eine Energiespeichereinrichtung der eingangs beschriebenen Art derart zu verbessern, dass diese als reales Gerät, insbesondere In einem Kraftfahrzeug, einsetzbar ist.

Diese Aufgabe wird bei einer Energiespeichereinrichtung der eingangs beschriebenen Art erfindungsgemäß durch die Kombination der kennzeichnender Merkmale von Anspruch 1 gelöst.

Der Vorteil der erfindungsgemäßen Lösung ist darin zu sehen, dass bei dieser negative Beeinträchtigungen der Umgebung aufgrund von aus den Kondensatorzellen austretenden chemischen Substanzen vermieden werden können, so dass beim Einsatz einer derartigen Energiespeichereinrichtung Beeinträchtigungen oder Gefahren für die Umgebung der Energiespeichereinrichtung ausgeschlossen werden können.

Besonders günstig ist es, dass in der Kondensatorkammer ein Sorptionsmaterial für aus den Kondensatorzellen austretende chemische Substanzen angeordnet ist. Ein derartiges Sorptionsmaterial erlaubt es, die aus den Kondensatorzellen austretenden chemischen Substanzen entweder durch Absorption oder Adsorption aufzunehmen und somit zu binden.

Derartige Sorptionsmaterialien können in unterschiedlichster Art und Weise ausgebildet sein, siehe z.B. EP 1 460 660 A1.

Eine vorteilhafte Lösung sieht vor, dass das Sorptionsmaterial auf der Basis eines organischen Polymers hergestellt ist.

Hinsichtlich der Ausbildung des Gehäuses wurden im Zusammenhang mit der bisherigen Erläuterung der einzelnen Ausführungsformen der erfindungsgemäßen Energiespeichereinrichtung keine näheren Angaben gemacht.

So sieht eine vorteilhafte Lösung vor, dass das Gehäuse eine Gehäuseschale mit einem sich ausgehend von einer Öffnung in die Gehäuseschale hineinerstreckenden Volumen aufweist, welches die Kondensatorkammer zumindest teilweise aufnimmt.

Der Vorteil dieser Lösung ist darin zu sehen, dass damit in einfacher Welse die Möglichkeit besteht, ein gasdichtes Gehäuse zu schaffen.

Noch vorteilhafter ist es, wenn das Volumen die Kondensatorkammer vollständig aufnimmt.

Um die Kondensatorkammer gasdicht abzuschließen, ist vorzugsweise vorgesehen, dass die Öffnung durch einen Deckel gasdicht verschließbar ist.

Ein derartiger gasdichter Verschluss der Öffnung durch einen Deckel lässt sich auf die verschiedenste Weise realisieren.

Beispielsweise wäre es denkbar, zwischen der Gehäuseschale und dem Deckel ein entsprechendes Dichtungsmaterial vorzusehen und den Deckel und die Gehäuseschale relativ zueinander zu verspannen.

Eine besonders zuverlässige Verbindung zwischen dem Deckel und der Gehäuseschale, insbesondere im Hinblick auf die Gasdichtheit, ist jedoch dann realisierbar, wenn der Deckel mit der Gehäuseschale durch Stoffschluss verbindbar ist.

Ein derartiger Stoffschluss ließe sich beispielsweise auch durch Verkleben des Deckels mit der Gehäuseschale realisieren.

Besonders vorteilhaft insbesondere im Hinblick auf die Gasdichtheit ist es jedoch, wenn der Deckel mit der Gehäuseschale verschweißt ist.

Ein derartiges Verschweißen des Deckels und der Gehäuseschale lässt sich vorzugsweise dadurch realisieren, dass die Gehäuseschale oder der Deckel einen zum Herstellen des Stoffschlusses erschmelzbaren Wulstbereich aufweist.

Ein derartiger Wulstbereich aus Material der Gehäuseschale oder des Deckels lässt sich in einfacher Weise erschmelzen um somit die Schweißverbindung herzustellen.

Um insbesondere die Schweißverbindung berührungslos herstellen zu können, ist vorzugsweise vorgesehen, dass der Deckel mit einem Randstreifen den Wulstbereich übergreift und dass der Randstreifen aus einem für Strahlung zum Erschmelzen des Wulstbereichs transparenten Material ist.

Damit lässt sich in einfacher Welse, und zwar durch den Randstreifen hindurch die Schweißverbindung zwischen dem Deckel und der Gehäuseschale herstellen.

Um auch beim Aufbau eines höheren Drucks in der Kondensatorkammer eine Deformation des Gehäuses zu vermeiden ist vorzugsweise vorgesehen, dass der Deckel in einem mittigen Bereich über mindestens ein Verankerungselement mit der Gehäuseschale verbindbar ist. Damit lässt sich eine druckstabilere Verbindung zwischen dem Deckel und der Gehäuseschale herstellen.

Vorzugsweise ist dabei vorgesehen, dass das Verankerungselement ein Schraubanker ist, mit welchem sich in einfacher Weise die Verbindung zwischen dem Deckel und der Gehäuseschale herstellen lässt.

Vorzugsweise ist dabei der Schraubanker derart ausgebildet, dass er den Deckel abgedichtet durchgreift, um auch im Bereich des Schraubankers einen gasdichten Abschluss der Kondensatorkammer sicherzustellen.

Im Zusammenhang mit der bisherigen Erläuterung der erfindungsgemäßen Energiespeichereinrichtung wurden keine näheren Angaben zur Anordnung der Wandlereinheit gemacht.

Prinzipiell könnte die Wandlereinheit in der Kondensatorkammer angeordnet sein, dies hat jedoch den großen Nachteil, dass dann bei aus den Kondensatorzellen austretenden chemischen Substanzen die Funktion der Wandlereinheit beeinträchtigt werden könnte.

Aus diesem Grund sieht eine vorteilhafte Lösung vor, dass die Wandlereinheit außerhalb der Kondensatorkammer angeordnet ist.

Damit sind in der Kondensatorkammer lediglich die Kondensatorzellen des Kondensatormoduls angeordnet und miteinander verschaltet, so dass aus den Kondensatorzellen austretende chemische Substanzen lediglich in begrenztem Umfang Schäden anrichten können.

Prinzipiell könnte die Wandlereinheit in einem separaten Gehäuse vorgesehen sein.

Eine vorteilhafte Lösung sieht jedoch vor, dass die Wandlereinheit in einer Schaltungskammer in demselben Gehäuse angeordnet ist. Diese Lösung ist für den Einbau in ein Kraftfahrzeug besonders kompakt.

Um eine geeignete Verbindung zwischen dem Kondensatormodul in der Kondensatorkammer und der Wandlereinheit zu schaffen, ist vorzugsweise vorgesehen, dass der Kondensatormodul über Hochstromkontakte mit der Wandlereinheit verbunden ist, so dass diese Kontakte in der Lage sind, große Ströme aus dem Kondensatormodul abzuziehen, insbesondere für den Ausgleich extremer Belastungen in dem Stromversorgungsnetz.

Um in jedem Fall die hermetische Isolierung der Kondensatorzellen in der Kondensatorkammer sicherzustellen, ist vorzugsweise auch vorgesehen, dass die Hochstromkontakte gasdicht aus der Kondensatorkammer herausgeführt sind.

Insbesondere ist dabei vorgesehen, dass die Hochstromkontakte gasdicht durch eine Wand des die Kondensatorkammer umschließenden Teils des Gehäuses hindurchgeführt sind.

Insbesondere ist es günstig, wenn die Hochstromkontakte durch eine die Schaltungskammer von der Kondensatorkammer trennende Wand hindurchgeführt sind.

Um in einfacher Weise eine raumsparende Verbindung zwischen den Kondensatorzellen in der Kondensatorkammer und der Wandlereinheit herstellen zu können, ist vorzugsweise vorgesehen, dass sich an die Kondensatorkammer eine Kontaktkammer anschließt, in welcher eine Verbindung mit Hochstromkontakten herstellbar ist, welche eine Wand der Kontaktkammer gasdicht durchsetzen.

Insbesondere ist dabei die von den Hochstromkontakten durchsetzte Wand zumindest Teil einer Trennwand zwischen der Kontaktkammer und einer Schaltungskammer des Gehäuses, die von der Kontaktkammer und der Kondensatorkammer hermetisch getrennt ist.

Vorzugsweise ist dabei die Schaltungskammer in demselben Gehäuse angeordnet, welches auch die Kondensatorkammer aufnimmt, ist jedoch von der Kondensatorkammer und der Kontaktkammer vollständig abgetrennt.

Weitere Merkmale und Vorteile der Erfindung sind Gegenstand der nachfolgenden Beschreibung sowie der zeichnerischen Darstellung eines Ausführungsbeispiels.

In der Zeichnung zeigen:

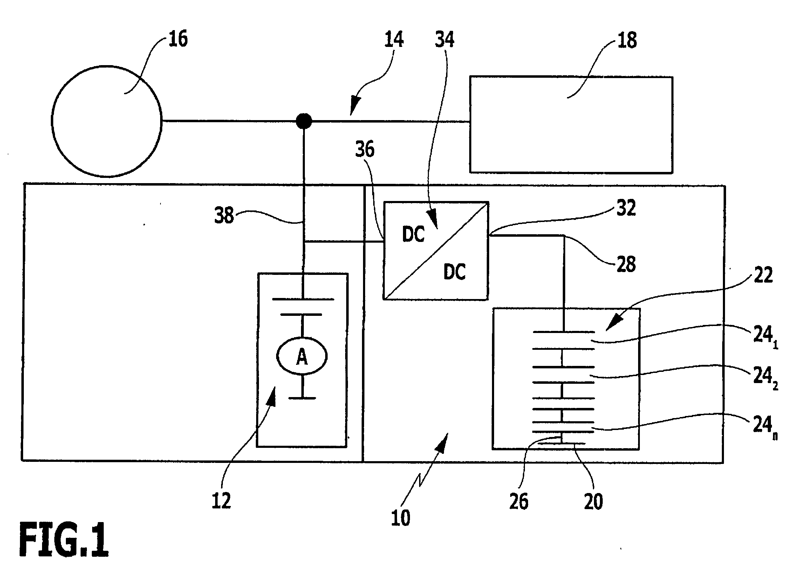

- Fig. 1: ein Schema einer erfindungsgemäßen Energiespeichereinrichtung;
- Fig.2: einen Längsschnitt längs Linie 2-2 in Fig. 3 bei zusammengebautem Gehäuse;
- Fig.3: eine Explosionsdarstellung einer erfindungsgemäßen Energiespeichereinrichtung mit einem Gehäuse und abgenommenem bodenseitigen Deckel;
- Fig.4: einen Schnitt längs Linie 4-4 in Fig. 3 und
- Fig. 5: eine vergrößerte Darstellung eines Bereichs A in Fig. 4.

Ein Ausführungsbeispiel einer erfindungsgemäßen Energiespeichereinrichtung 10, ist beispielsweise ergänzend zu einer Batterie 12 in einem Stromversorgungsnetz 14 eines Kraftfahrzeugs angeordnet, das zusätzlich zu der Batterie 12 und der Energiespeichereinheit 10 beispielsweise noch einen Generator 16 sowie eine Vielzahl von Verbrauchern 18 aufweist, die alle zwischen dem Stromversorgungsnetz 14 und Masse 20 liegen.

Die Energiespeichereinheit 10 umfasst einen Kondensatormodul 22, welcher aus einer Vielzahl von in Reihe geschalteten Kondensatorzellen 24 aufweist.

Der Kondensatormodul 22 liegt beispielsweise mit einem ersten Anschluss 26 auf Masse 20 und ist mit einem zweiten Anschluss 28 mit einem Ausgang 32 einer DC/DC-Wandlereinheit 34 verbunden, deren Eingang 36 mit einer Versorgungsleitung 38 des Stromversorgungsnetzes 14 verbunden ist, die beispielsweise auf einer Spannung zwischen ungefähr 8 und ungefähr 14 Volt liegen kann.

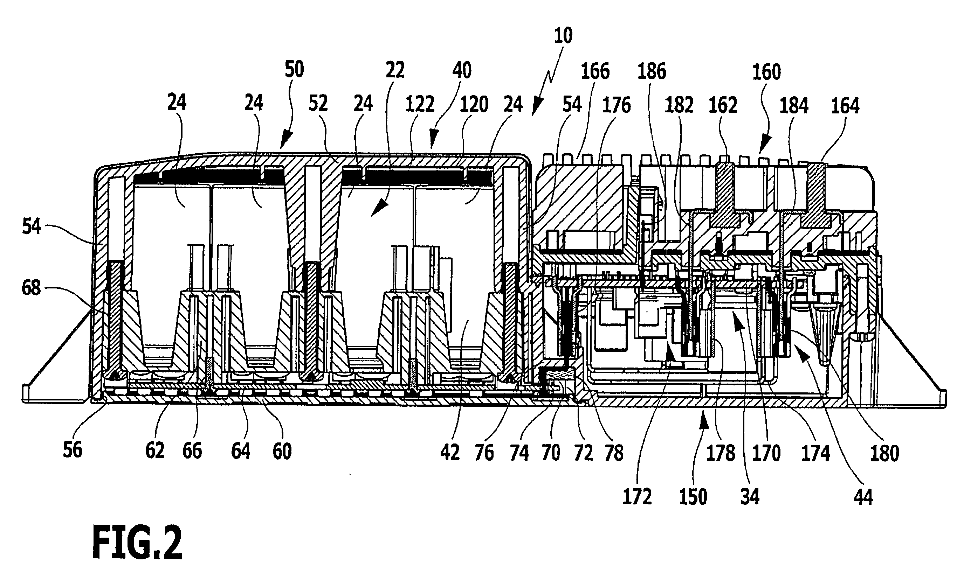

Wie in Fig. 2 dargestellt, ist die Energiespeichereinheit 10 in einem Gehäuse 40 angeordnet, welches einerseits eine Kondensatorkammer 42 zur Aufnahme der gesamten Kondensatorzellen 24 des Kondensatormoduls 22 aufweist und andererseits eine Schaltungskammer 44, in welcher die gesamte elektronische Schaltung der Wandlereinheit 34 und gegebenenfalls noch weitere Schaltungen weiterer Einheiten angeordnet sind.

Die Kondensatorkammer 42 und die Schaltungskammer 44 sind dabei hermetisch voneinander getrennt, um in der Kondensatorkammer 42 optimale Bedingungen für die Kondensatorzellen 24 zu schaffen, die unabhängig von den Bedingungen gewählt werden können, welche in der Schaltungskammer 44 für die elektrische Schaltung vorliegen.

Zur Ausbildung der Kondensatorkammer 42 weist das Gehäuse 40 eine Gehäuseschale 50 auf, welche einen Deckel 52 und Seitenwände 54 umfasst, die sich bis zu einer Öffnung 56 der Gehäuseschale 50 erstrecken, wobei die Öffnung 56 der Gehäuseschale 50 durch einen dem Deckel 52 gegenüberliegenden bodenseitigen Deckel 60 verschließbar ist.

Die einzelnen Kondensatorzellen 24 werden in der Kondensatorkammer 42 einerseits durch einen Kondensatorhalter 62 und andererseits durch eine Kondensatorleiterplatte 64 relativ zueinander fixiert, wobei der Kondensatorhalter 62 und die Kondensatorleiterplatte 64 relativ zueinander durch Halteelemente 66, beispielsweise Schrauben, fixiert sind und andererseits der Kondensatorhalter 62 durch Halteelemente 68, beispielsweise ebenfalls Schrauben, in der Gehäuseschale 50 fixiert ist.

Die Kondensatorzellen 24 sind mit dem Kondensatorhalter 62 und der Kondensatorleiterplatte 64 so in die Gehäuseschale 50 eingesetzt, dass die Kondensatorleiterplatte 64 dem bodenseitigen Deckel 60 zugewandt ist und nahe desselben verläuft.

Die Kondensatorleiterplatte 64 trägt dabei die elektrischen Leiterbahnen zur Verschaltung der Kondensatorzellen 24 und stellt eine Verbindung mit Hochstromkontakten 70 her, welche in einer sich an die Kondensatorkammer 42 anschließenden und mit dieser verbundenen und in der Gehäusehalle 50 ebenfalls vorgesehenen Kontaktkammer 72 angeordnet sind, in welche sich die Kondensatorleiterplatte 64 mit einem Kontaktbereich 74 hinein erstreckt, so dass in den Kontaktbereich 74 hineinführende Leiterbahnen mit den Hochstromkontakten 70, beispielsweise durch Löten, verbindbar sind.

Die Hochstromkontakte 70 durchsetzen eine die Kontaktkammer 72 von der Schaltungskammer 44 trennende Wand 76, wobei sie vorzugsweise in diese eingespritzt sind, und zusätzlich sind die Hochstromkontakte 70 noch in eine die Wand 76 überdeckende Vergussmasse 78 eingebettet, um die Hochstromkontakte 70 gasdicht durch die Wand 76 hindurchführen zu können.

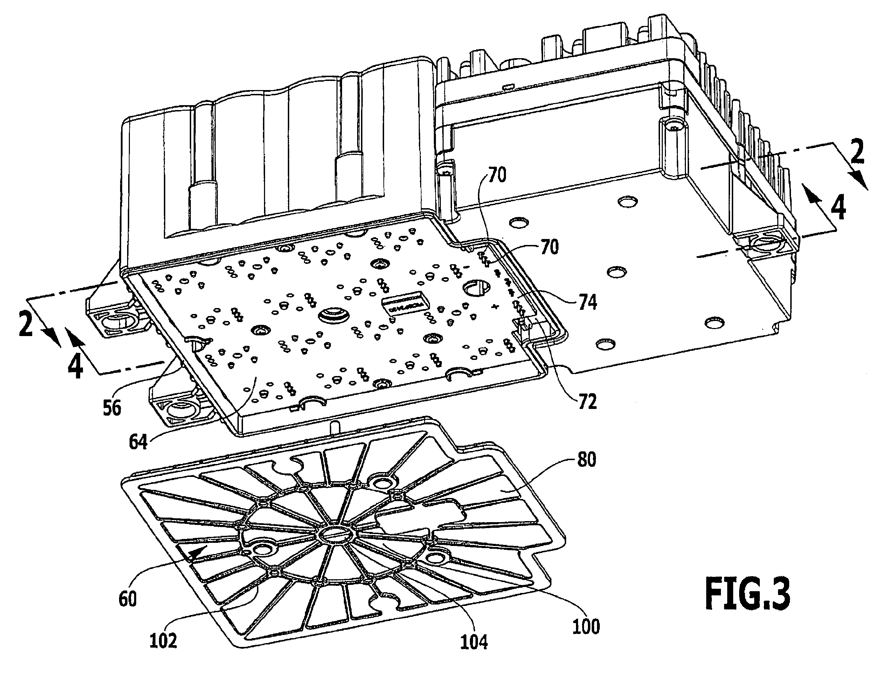

Wie in Fig. 3 dargestellt, erstreckt sich der bodenseitige Deckel 60 zum Verschluss der Kondensatorkammer 42 nicht nur über diese, sondern auch noch mit einem Deckelansatz 80 über die Kontaktkammer 72, um beide gemeinsam zu verschließen, wobei die Öffnung 56 der Gehäuseschale 50 auch um die Kontaktkammer 72 herum verläuft.

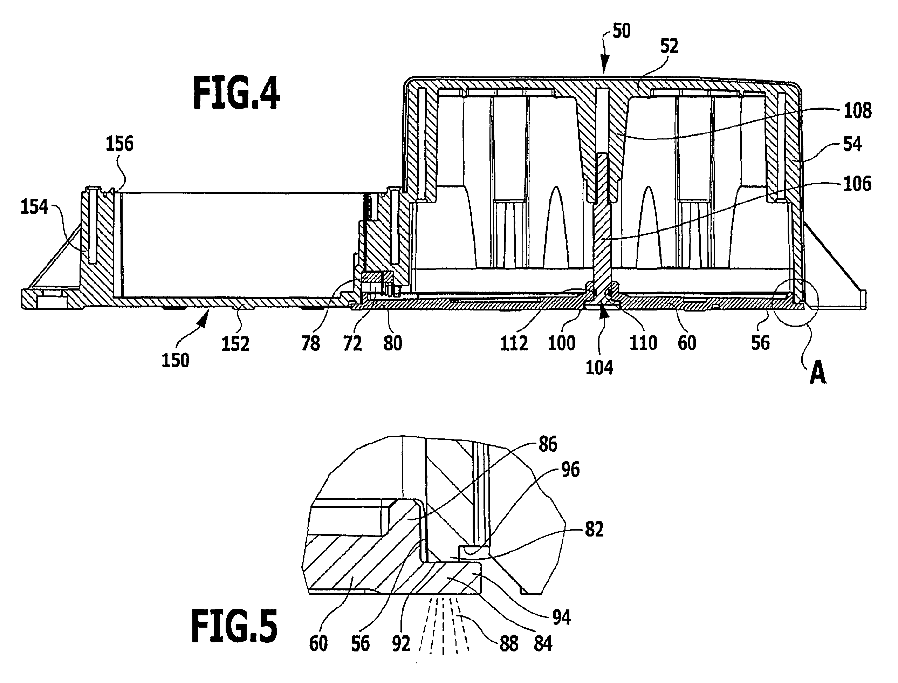

Wie in Fig. 4 und Fig. 5 im Detail dargestellt, verläuft entlang der Öffnung 56 und um diese herum ein Wulstbereich 82 und sowohl der bodenseitige Deckel 60 ais auch der Deckelansatz 80 übergreifen den Wulstbereich 82 mit einem Randstreifen 84, der seitlich nach außen über einen in die Öffnung 56 eingreifenden Führungssteg 86 übersteht, der den Deckel 60 sowie den Deckelansatz 80 relativ zur Öffnung 56 in Richtung einer Flächenausdehnung des Deckels 60 mit dem Deckelansatz 80 relativ zur Gehäuseschale 50 beim Einsetzen führt.

Vorzugsweise sind entweder der Deckel 60 mit dem Deckelansatz 80 oder zumindest der Randstreifen 84 für einfallende energiereiche Strahlung 88, beispielsweise Laserstrahlung, transparent ausgebildet, so dass mit der energiereichen Strahlung 88, die durch den Randstreifen 84 hindurchtritt, der Wulstbereich 82 erschmelzbar ist, um somit zwischen dem Wulstbereich 82 und dem Randstreifen 84 eine stoffschlüssige Verbindung herzustellen.

Vorzugsweise erstreckt sich der Randstreifen 84 noch über einen Materialaufschmelzbereich 92 mit einem Außenrand 94 hinaus und der Wulstbereich 82 erhebt sich über einen auf einer der Öffnung 56 gegenüberliegenden Seite des Wulstbereichs 82 umlaufenden Stützrand 96, so dass bei Erschmelzen des Wulstbereichs 82 im Materialaufschmelzbereich 92 der Deckel 60 mit dem Deckelansatz 80 soweit aufgedrückt werden kann, bis der Außenrand 94 auf dem Stützrand 96 aufliegt.

Durch die sich im Materialaufschmelzbereich 92 ergebende stoffschlüssige Verbindung zwischen dem bodenseitigen Deckel 60 und dem Deckelansatz 80 ist eine stabile Verbindung zwischen diesen und der Gehäuseschale 50 herstellbar, die allerdings beim Aufbau eines Überdrucks in der Kondensatorkammer 42 und der Kontaktkammer 72 ein Aufwölben eines mittigen Bereichs 100 des Deckels 60 nicht verhindern kann.

Aus diesem Grund ist der Deckel 60 noch mit Versteifungsrippen 102 versehen, die von dem Randstreifen 84 zum mittigen Bereich 100 hin verlaufen, insbesondere, wie in Fig. 3 dargestellt, zu einem Verankerungselement 104 hin verlaufen und sich beispielsweise radial zu dem Verankerungselement 104 über die Ausdehnung des Deckels 60 erstrecken.

Das Verankerungselement 104 ist, wie in Fig. 4 dargestellt, durch einen Schraubanker 106 gebildet, der in eine Aufnahme 108 der Gehäuseschale 50 einschraubbar ist, wobei die Aufnahme 108 beispielsweise an den oberen Deckel 52 der Gehäuseschale 50 angeformt ist.

Der Schraubanker 106 durchsetzt einen Durchbruch 110, der im mittigen Bereich 100 des Deckels 60 vorgesehen ist, und ist gegenüber dem Durchbruch 110 mit einer Dichtung 112 abgedichtet, um somit ebenfalls im Bereich des Schraubankers 106 sicherzustellen, dass die Kondensatorkammer 42 gegenüber der Umgebung gasdicht abgeschlossen ist.

In der gasdicht abgeschlossenen Kondensatorkammer 42 können bei Alterung der Kondensatorzellen 24 Volumenexpansionen derselben auftreten sowie auch chemische Stoffe aus diesen austreten. Aus diesem Grund ist zwischen dem Deckel 52 und den diesem zugewandten Seiten der Kondensatorzellen 24 ein Zwischenraum 120 vorgesehen, in welchem ein Füllmaterial 122 angeordnet ist, das elastisch ausgebildet ist und somit Volumenausdehnungen der Kondensatorzellen 24 kompensieren kann. Darüber hinaus ist das Füllmaterial 122 aber auch mit einem Sorptionsmaterial für aus den Kondensatorzellen 24 austretende chemische Substanzen versehen.

Beim Einsatz von elektrochemischen Doppelschichtkondensatoren als Kondensatorzellen 24 erfolgt aufgrund von Alterungseffekten in den Kondensatorzellen 24 eine interne Druckerhöhung und ein Außengehäuse der Kondensatorzellen ist so konzipiert, dass dieses nach Überschreiten eines vorgegebenen Druckniveaus definiert reißt. In diesem Fall tritt aus den Kondensatorzellen 24 Acetonitril aus und dieses Acetonitril kann bei geeigneter Ausbildung des Füllmaterials 122 von diesem aufgenommen werden.

Beispielsweise ist das Füllmaterial 122 mit organischen Polymeren als Sorptionsmaterial 124 versehen, welche durch Sorption, das heißt Absorption und Adsorption, das aus den Kondensatorzellen 24 austretende Acetonitril sorbieren, wobei die Auswahl der Materialien nicht nur hinsichtlich eines guten Absorptionsverhaltens und eines guten Adsorptionsverhaltens erfolgt, sondern auch hinsichtlich eines möglichst günstigen Desorptionsverhaltens, um die Freisetzung von einmal absorbiertem oder adsorbiertem Acetonitril möglichst gering zu halten.

Für einen einfachen Zusammenbau der Energiespeichereinrichtung ist es günstig, wenn das mit dem Sorptionsmaterial 124 versehene Füllmaterial 122 in Form eines Füllmaterialpolsters 126 zwischen dem Deckel 52 und den Kondensatorzellen 24 angeordnet ist.

Die Schaltungskammer 44 wird gebildet durch eine einstückig an die erste Gehäuseschale 50 angeformte zweite Gehäuseschale 150, die, wie in Fig. 2, 3 und 4 dargestellt, einen bodenseitigen Deckel 152 aufweist, von welchem sich Seitenwände 154 erheben, die bis zu einer Öffnung 156 reichen, welche durch eine Deckeleinheit 160 verschließbar ist, wobei die Deckeleinheit 160 einerseits Hochstromanschlüsse 162 und 164 und andererseits Kühlrippen 166 aufweist, wobei die Kühlrippen 166 zur Kühlung von Leistungsbauteilen der Wandlereinheit 34 dienen.

Die Wandlereinheit 34 weist ihrerseits eine auf einer Schaltungsplatine 170 angeordnete Wandlerschaltung 172 auf, welche die Leistungsbauteile umfasst, die durch die Kühlrippen 166 kühlbar sind.

Darüber hinaus sind Hochstrompfade der Wandlerschaltung 172 durch Stanzgitter 174 realisiert, welche die hohen Ströme führen.

Zur Verbindung der Schaltungsplatine 170 mit den Hochstromkontakten 70 ist die Schaltungsplatine 170 mit Steckkontakten 176 versehen, welche auf die in den Schaltungsraum 44 hineinragenden Teile der Hochstromkontakte 70 aufsteckbar sind und andererseits ist die Schaltungsplatine 170 mit weiteren Steckkontakten 178, 180 versehen, in welche zu den Hochstromanschlüssen 162 und 164 führende Kontaktbügel 182, 184 einsteckbar sind, wobei die Kontaktbügel 182 und 184 in der Deckeleinheit 160 verankert, vorzugsweise in diese eingelassen sind.

Ferner sind in der Deckeleinheit 160 noch Steuerkontakte 186 vorgesehen, welche ebenfalls mit der Schaltungsplatine 170 verbunden sind, um der Wandlerschaltung 172 Steuersignale von externen Steuergeräten zuführen zu können.

## Patentansprüche

1. Energiespeichereinrichtung (10) umfassend eine Wandlereinheit (34) und ein mit der Wandlereinheit (34) zusammenwirkendes Kondensatormodul (22), wobei
ein Kondensatorzellen (24) des Kondensatormoduls (22) aufnehmendes Gehäuse (40) vorgesehen ist, **dadurch gekennzeichnet, dass** das Gehäuse (40) eine die Kondensatorzellen (24) aufnehmende Kondensatorkammer (42) und einen Deckel (52) aufweist, und dass die Kondensatorkammer (42) gasdicht abgeschlossen ist, wobei zwischen dem Deckel (52) und den Kondensatorzellen (24) ein Füllmaterial (122) angeordnet ist, das elastisch ausgebildet ist, um Volumenausdehnungen der Kondensatorzellen (24) zu kompensieren, und wobei das Füllmaterial mit einem Sorptionsmaterial für aus den Kondensatorzellen (24) austretende chemische Substanzen versehen ist.

2. Energiespeichereinrichtung nach Anspruch 1,
**dadurch gekennzeichnet, dass**
das Sorptionsmaterial (124) auf der Basis eines organischen Polymers hergestellt ist.

3. Energiespeichereinrichtung nach einem der voranstehenden Ansprüche,
**dadurch gekennzeichnet, dass**
das Gehäuse (40) eine Gehäuseschale (50) mit einem sich ausgehend von einer Öffnung (56) in die Gehäuseschale (50) hineinerstreckenden Volumen aufweist, welches die Kondensatorkammer (42) zumindest teilweise aufnimmt.

4. Energiespeichereinrichtung nach Anspruch 3,
**dadurch gekennzeichnet, dass**
das Volumen die Kondensatorkammer (42) vollständig aufnimmt.

5. Energiespeichereinrichtung nach Anspruch 3 oder 4,
**dadurch gekennzeichnet, dass**
die Öffnung (56) durch einen Deckel (60) gasdicht verschließbar ist.

6. Energiespeichereinrichtung nach Anspruch 5,
**dadurch gekennzeichnet, dass**
der Deckel (60) mit der Gehäuseschale (50) durch Stoffschluss verbindbar ist.

7. Energiespeichereinrichtung nach Anspruch 6,
**dadurch gekennzeichnet, dass**
der Deckel (60) mit der Gehäuseschale (50) verschweißt ist.

8. Energiespeichereinrichtung nach Anspruch 6 oder 7,
**dadurch gekennzeichnet, dass**
die Gehäuseschale (50) oder der Deckel (60) einen zum Herstellen des Stoffschlusses erschmelzbaren Wulstbereich (82) aufweist.

9. Energiespeichereinrichtung nach Anspruch 8,
**dadurch gekennzeichnet, dass**
der Deckel (60) mit einem Randstreifen (84) den Wulstbereich (82) übergreift und dass der Randstreifen (84) aus einem für Strahlung zum Erschmelzen des Wulstbereichs (82) transparenten Material ist.

10. Energiespeichereinrichtung nach einem der voranstehenden Ansprüche,
**dadurch gekennzeichnet, dass**
der Deckel (60) in einem mittigen Bereich (100) über mindestens ein Verankerungselement (104) mit der Gehäuseschale (50) verbindbar ist.

11. Energiespeichereinrichtung nach Anspruch 10,
**dadurch gekennzeichnet, dass**
das Verankerungselement (104) ein Schraubanker (106) ist.

12. Energiespeichereinrichtung nach Anspruch 11,
**dadurch gekennzeichnet, dass**
der Schraubanker (106) den Deckel (60) abgedichtet durchgreift.

13. Energiespeichereinrichtung nach einem der voranstehenden Ansprüche
**dadurch gekennzeichnet, dass**
die Wandlereinheit (34) außerhalb der Kondensatorkammer (42) angeordnet ist.

14. Energiespeichereinrichtung nach Anspruch 13,
**dadurch gekennzeichnet, dass**
die Wandlereinheit (34) in einer Schaltungskammer in demselben Gehäuse (40) angeordnet ist.

15. Energiespeichereinrichtung nach Anspruch 13 oder 14,
**dadurch gekennzeichnet, dass**
der Kondensatormodul (22) über Hochstromkontakte (70) mit der Wandlereinheit (34) verbunden ist.

16. Energiespeichereinrichtung nach Anspruch 15,
**dadurch gekennzeichnet, dass**
die Hochstromkontakte (70) gasdicht aus der Kondensatorkammer (42) herausgeführt sind.

## Claims

1. An energy storage device (10) comprising a transducer unit (34) and a capacitor module (22) which interacts with the transducer unit (34), wherein a housing (40) is provided to accommodate the capacitor cells (24) of the capacitor module (22),
**characterized in that**
the housing (40) comprises a capacitor chamber (42) accommodating the capacitor cells (24) and a cover (52), and that the capacitor chamber (42) has a gas-tight seal wherein an elastic filler material (122) is provided between the cover (52) and the capacitor cells (24) in order to compensate for volume expansions of the capacitor cells (24), and wherein the filler material is provided with a sorption material for chemical substances leaking from the capacitor cells (24).

2. The energy storage device according to claim 1,
**characterized in that**
the sorption material (124) is made from an organic polymer.

3. The energy storage device according to any one of the preceding claims,
**characterized in that**
the housing (40) exhibits a housing shell (50) having a volume extending inward from an opening (56) in said housing shell (50) which at least partly accommodates the capacitor chamber (42).

4. The energy storage device according to claim 3,
**characterized in that**
the volume wholly accommodates the capacitor chamber (42).

5. The energy storage device according to claim 3 or 4,
**characterized in that**
the opening (56) can be sealed by a cover (60) so as to be gas-tight.

6. The energy storage device according to claim 5,
**characterized in that**
the cover (60) can be connected to the housing shell (50) by means of an adhesive bond.

7. The energy storage device according to claim 6,
**characterized in that**
the cover (60) and the housing shell (50) are welded together.

8. The energy storage device according to claim 6 or 7,
**characterized in that**
the housing shell (50) or the cover (60) exhibits a meltable bead area (82) for creating the adhesive bond.

9. The energy storage device according to claim 8,
**characterized in that**
the cover (60) overlaps the bead area (82) by means of an edge strip (84) and that the edge strip (84) is of a material transparent to radiation for melting the bead area (82).

10. The energy storage device according to any one of the preceding claims,
**characterized in that**
the cover (60) can be connected to the housing shell (50) in a central area (100) by means of at least one anchoring element (104).

11. The energy storage device according to claim 10,
**characterized in that**
the anchoring element (104) is a screw anchor (106).

12. The energy storage device according to claim 11,
**characterized in that**
the screw anchor (106) projects through the cover (60) to seal same.

13. The energy storage device according to any one of the preceding claims,
**characterized in that**
the transducer unit (34) is disposed outside of the capacitor chamber (42).

14. The energy storage device according to claim 13,
**characterized in that**
the transducer unit (34) is disposed in a circuit chamber in the same housing (40).

15. The energy storage device according to claim 13 or 14,
**characterized in that**
the capacitor module (22) is connected to the transducer unit (34) by means of high-current contacts (70).

16. The energy storage device according to claim 15,
**characterized in that**
the high-current contacts (70) lead out of the capacitor chamber (42) in gas-tight manner.

## Revendications

1. Système d'emmagasinage d'énergie (10) comprenant une unité de conversion (34) et un module condensateur (22) qui coopère avec l'unité de conversion (34), dans lequel il est prévu un boîtier (40) qui reçoit des cellules de condensateur (24) du module condensateur (22), **caractérisé en ce que** le boîtier (40) comprend une chambre de condensateur (42) qui reçoit les cellules de condensateur (24) et un couvercle (52), et **en ce que** la chambre de condensateur (42) est fermée de manière étanche aux gaz, dans lequel un matériau de remplissage (122) est agencé entre le couvercle (52) et les cellules de condensateur (24), matériau qui est réalisé élastique afin de compenser des dilatations de volume des cellules de condensateur (24), et dans lequel le matériau de remplissage est doté d'un matériau de sorption pour des substances chimiques s'échappant des cellules de condensateur (24).

2. Système d'emmagasinage d'énergie selon la revendication 1,
**caractérisé en ce que** le matériau de sorption (124) est produit sur la base d'un polymère organique.

3. Système d'emmagasinage d'énergie selon l'une des revendications précédentes,
**caractérisé en ce que** le boîtier (40) comprend une coque de boîtier (50) avec un volume qui s'étend vers l'intérieur de la coque de boîtier (50) en partant d'une ouverture (56), et qui reçoit au moins partiellement la chambre de condensateur (42).

4. Système d'emmagasinage d'énergie selon la revendication 3,
**caractérisé en ce que** le volume reçoit entièrement la chambre de condensateur (42).

5. Système d'emmagasinage d'énergie selon la revendication 3 ou 4,
**caractérisé en ce que** l'ouverture (56) est susceptible d'être refermée par un couvercle (60) de manière étanche aux gaz.

6. Système d'emmagasinage d'énergie selon la revendication 5,
**caractérisé en ce que** le couvercle (60) est susceptible d'être relié à la coque de boîtier (50) par coopération de matière.

7. Système d'emmagasinage d'énergie selon la revendication 6,
**caractérisé en ce que** le couvercle (60) est soudé avec la coque de boîtier (50).

8. Système d'emmagasinage d'énergie selon la revendication 6 ou 7,
**caractérisé en ce que** la coque de boîtier (50) ou le couvercle (60) comporte une zone en bourrelet (82) capable d'être mise en fusion pour réaliser la coopération de matière.

9. Système d'emmagasinage d'énergie selon la revendication 8,
**caractérisé en ce que** le couvercle (60) coiffe la zone en bourrelet (82) avec une bande de bordure (84), et **en ce que** la bande de bordure (84) est en un matériau transparent au rayonnement destiné à mettre la zone en bourrelet (82) en fusion.

10. Système d'emmagasinage d'énergie selon l'une des revendications précédentes,
**caractérisé en ce que** le couvercle (60) est susceptible d'être relié à la coque de boîtier dans une zone médiane (100) via au moins un élément d'ancrage (104).

11. Système d'emmagasinage d'énergie selon la revendication 10,
**caractérisé en ce que** l'élément d'ancrage (104) est un ancrage à vis (106).

12. Système d'emmagasinage d'énergie selon la revendication 11,
**caractérisé en ce que** l'ancrage à vis (106) traverse le couvercle (60) de manière étanchée.

13. Système d'emmagasinage d'énergie selon l'une des revendications précédentes,
**caractérisé en ce que** l'unité de conversion (34) est agencée à l'extérieur de la chambre de condensateur (42).

14. Système d'emmagasinage d'énergie selon la revendication 13,
**caractérisé en ce que** l'unité de conversion (34) est agencée dans le même boîtier (40) dans une chambre à circuit.

15. Système d'emmagasinage d'énergie selon la revendication 13 14,
**caractérisé en ce que** le module de condensateur (22) est relié à l'unité de conversion (34) via des contacts (70) capables de laisser passer un courant important.

16. Système d'emmagasinage d'énergie selon la revendication 15,
**caractérisé en ce que** les contacts capables de laisser passer un courant important (70) sont menés à l'extérieur de la chambre de condensateur (42) de manière étanche aux gaz.
